# EUROPEAN PATENT APPLICATION

(11) **EP 2 690 938 A1**
(43) Date of publication of application: **29.01.2014**
(21) Application number: 12761154.9
(22) Date of filing: 14.03.2012
(51) Int. Cl.: H05K 3/10, H01B 5/14, H01B 13/00, H01L 21/28, H01L 21/288, H01L 21/3205, H01L 21/768, H01L 23/532, H05K 3/12, H05K 3/24

(54) **METHOD FOR FORMING COPPER WIRING, METHOD FOR MANUFACTURING WIRING SUBSTRATE, AND WIRING SUBSTRATE**

(30) Priority: 24.03.2011 JP 2011065885
(71) Applicant: FUJIFILM Corporation, Tokyo 106-8620 (JP)
(72) Inventor: MATAKI, Hiroshi, Ashigarakami-gun Kanagawa 258-8577 (JP)
(74) Representative: Klunker . Schmitt-Nilson . Hirsch
(86) International application number: PCT/JP2012/056525
(87) International publication number: WO 2012/128140

(57) **Abstract**

Provided are a method of forming copper wiring, a method of manufacturing a wiring board, and a wiring board, which are capable of improving conductivity and suppressing deterioration over a period of time of copper wiring. The method of forming copper wiring includes: a wiring pattern formation step of depositing a first suspension (12) onto a substrate (10) to form a wiring pattern of the first suspension (12) on the substrate (10), the first suspension (12) including dispersed first copper particles (14) having an average particle diameter that is not smaller than 100 nm; a drying step of drying the first copper particles (14) at a temperature lower than 150°C; a second suspension deposition step of depositing a second suspension (16) onto the wiring pattern, the second suspension (16) including dispersed second copper particles (18) having an average particle diameter that is smaller than the average particle diameter of the first copper particles (14); a compaction step of reducing voids between the first and second copper particles (14, 18); a heat application step of applying heat to the first and second copper particles (14, 18); and a reducing treatment step of subjecting the first and second copper particles (14, 18) to a reducing treatment.

## Description

### Technical Field

The present invention relates to a method of forming copper wiring, a method of manufacturing a wiring board, and a wiring board, and more particularly to a method of forming copper wiring, a method of manufacturing a wiring board, and a wiring board, in which copper wiring is formed with use of copper particles having different particle diameters.

### Background Art

Conventionally, wiring boards which include insulating substrates and wiring patterns made of metal films formed on the surfaces of the insulating substrates, have widely been used for electronic components and semiconductor elements.

In a case where the wiring pattern is formed by using a suspension with relatively large copper particles (e.g., having particle diameters of not smaller than 100 nm) dispersed therein, conductivity of the metal film declines due to deterioration over a period of time because there are large voids between the copper particles forming the metal film.

In a case where copper nanoparticles (e.g., having particle diameters of smaller than 100 nm) are used for improving denseness of the metal film, the copper nanoparticles completely oxidize easily in the air in the process of forming the wiring pattern, it is then impossible to make the particles bond together even with a reducing treatment performed thereafter, and the conductivity of the wiring pattern cannot be realized. Moreover, since costs of particles having small particle diameters are high, a manufacturing cost of wiring boards is increased.

For example, Patent Literature 1 describes a method of forming copper wiring by applying on a substrate a paste with copper particles having different particle diameters dispersed therein and calcining the paste. Patent Literature 2 describes a method of forming wiring by ejecting and depositing on a substrate two kinds of liquids which are respectively prepared by dispersing conductive fine particles in suspending media that are different from each other. Patent Literature 3 describes a method of forming wiring with a plurality of metallic thin films having different crystal grain sizes.

### Citation List

### Patent Literature

Patent Literature 1: Japanese Patent Application Publication No. 10-308120
Patent Literature 2: Japanese Patent Application Publication No. 2003-311196
Patent Literature 3: Japanese Patent Application Publication No. 05-013412

### Summary of Invention

### Technical Problem

In the method described in Patent Literature 1, the particles having the different particle diameters are mixed into one paste and are applied on the substrate, while in the method described in Patent Literature 2, the two kinds of liquids are used which are different in the properties of their suspending media but are identical in the properties of their conductive fine particles; and therefore, neither of the cases can sufficiently fill voids between the particles. In the method described in Patent Literature 3, over the first metallic thin film, the second metallic thin film having the crystal grain size smaller than the crystal grain size of the first metallic thin film is formed; however, no study has been made for filling the voids between the particles.

The present invention has been contrived in view of these circumstances, an object thereof being to provide a method of forming copper wiring, a method of manufacturing a wiring board, and a wiring board, which are capable of improving conductivity and suppressing deterioration over a period of time by reducing voids between copper particles.

### Solution to Problem

In order to attain the aforementioned object, a method of forming copper wiring according to one aspect of the present invention includes: a wiring pattern formation step of depositing a first suspension onto a substrate to form a wiring pattern of the first suspension on the substrate, the first suspension including dispersed first copper particles having an average particle diameter that is not smaller than 100 nm; after the wiring pattern formation step, a drying step of drying the first copper particles in the wiring pattern at a temperature lower than 150°C; after the drying step, a second suspension deposition step of depositing a second suspension onto the wiring pattern, the second suspension including dispersed second copper particles having an average particle diameter that is smaller than the average particle diameter of the first copper particles; after the second suspension deposition step, a compaction step of reducing voids between the first and second copper particles in the wiring pattern; after the compaction step, a heat application step of applying heat to the first and second copper particles in the wiring pattern; and after the heat application step, a reducing treatment step of subjecting the first and second copper particles in the wiring pattern to a reducing treatment.

According to this aspect, it is possible to insert the second copper particles into voids between the first copper particles in the wiring pattern, by forming the wiring pattern with the first copper particles having the average particle diameter that is not smaller than 100 nm and thereafter depositing the second copper particles having the average particle diameter that is smaller than the average particle diameter of the first copper particles onto the wiring pattern. Thus, it is possible to reduce the voids present between the copper particles at the time of forming the wiring pattern. Moreover, it is possible to increase mutual contact areas between the copper particles and to thereby improve the conductivity of the copper wiring, by reducing the voids between the copper particles with the compaction treatment, and thereafter making the copper particles oxidize and bond to each other with the heat application. Further, it is possible to improve temporal stability of the copper wiring because the voids between the copper particles forming the wiring pattern can be reduced.

Preferably, the compaction step includes a pressure application step of applying pressure to the first and second copper particles in the wiring pattern.

According to this aspect, it is possible to perform the compaction treatment to reduce the voids between the copper particles by applying pressure to the first and second copper particles in the wiring pattern.

Preferably, the wiring pattern formation step includes a first suspension ejection step of ejecting droplets of the first suspension by means of an inkjet method to deposit the droplets of the first suspension onto the substrate; and the second suspension deposition step includes a second suspension ejection step of ejecting droplets of the second suspension by means of the inkjet method to deposit the droplets of the second suspension onto the wiring pattern.

According to this aspect, by using the inkjet method in the wiring pattern formation step and in the second suspension deposition step, it is possible to easily perform the steps. Moreover, it is possible to selectively deposit the first and second suspensions only to a portion on the substrate which is necessary for the formation of the wiring pattern, and it is possible to thereby suppress use amounts of the first and second suspensions and to thus lower a manufacturing cost of the copper wiring.

Preferably, a size of the droplets of the first suspension in the first suspension ejection step is larger than a size of the droplets of the second suspension in the second suspension ejection step.

According to this aspect, it becomes easy to insert the second suspension into the voids between the first copper particles.

Preferably, the first suspension ejection step and the second suspension ejection step are carried out respectively by means of inkjet heads different from each other.

According to this aspect, it is possible to efficiently perform the ejections of the first and second suspensions.

Preferably, the average particle diameter of the second copper particles is not larger than 1/10 of the average particle diameter of the first copper particles.

According to this aspect, it becomes easy to insert the second copper particles into the voids between the first copper particles.

Preferably, a viscosity of the second suspension is lower than a viscosity of the first suspension.

According to this aspect, it becomes easy to insert the second suspension into the voids between the first copper particles.

Moreover, in order to attain the aforementioned object, a method of manufacturing a wiring board according to one aspect of the present invention includes the above-described method of forming copper wiring.

According to this aspect, the method of manufacturing the wiring board is adequate since it is possible to form the copper wiring with improved conductivity and temporal stability.

Furthermore, in order to attain the aforementioned object, a wiring board according to one aspect of the present invention includes the copper wiring formed by the above-described method of forming copper wiring.

According to this aspect, the wiring board can include the copper wiring with improved conductivity and temporal stability.

### Advantageous Effects of Invention

According to the present invention, copper particles having a relatively small particle diameter are inserted into voids between copper particles having a relatively large particle diameter, then the voids are further reduced by a compaction treatment, and thereafter the copper particles are made to oxidize and bond to each other by applying heat; therefore, it is possible to increase mutual contact areas between the copper particles and to thereby improve conductivity and suppress deterioration over a period of time of copper wiring.

### Brief Description of Drawings

[Fig. 1A] A view for explaining a method of forming copper wiring according to an embodiment of the present invention.
[Fig. 1B] A view for explaining the method of forming copper wiring according to the embodiment of the present invention.
[Fig. 1C] A view for explaining the method of forming copper wiring according to the embodiment of the present invention.
[Fig. 1D] A view for explaining the method of forming copper wiring according to the embodiment of the present invention.
[Fig. 1E] A view for explaining the method of forming copper wiring according to the embodiment of the present invention.
[Fig. 1F] A view for explaining the method of forming copper wiring according to the embodiment of the present invention.
[Fig. 2A] A view for explaining a method of forming copper wiring according to a comparative example.
[Fig. 2B] A view for explaining a method of forming copper wiring according to a comparative example.

### Description of Embodiments

Hereinafter, preferred embodiments of the present invention are described with reference to the accompanying drawings.

### {Wiring Pattern Formation Step}

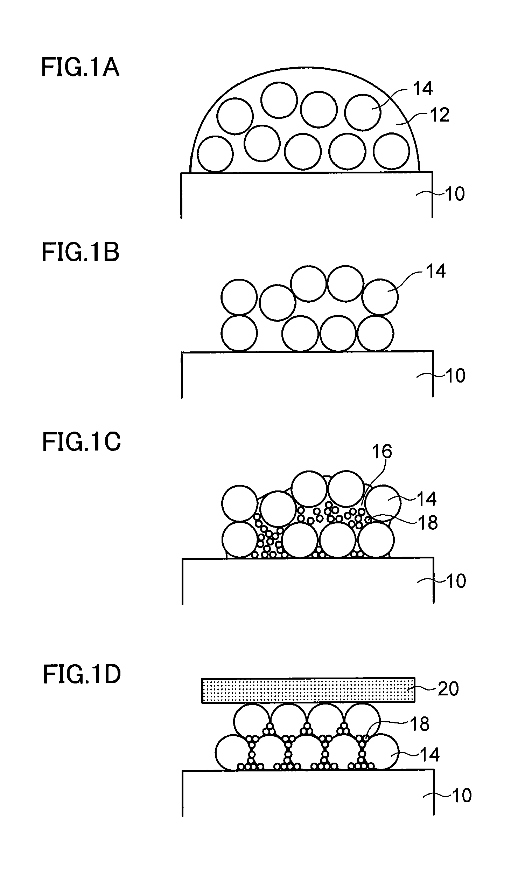

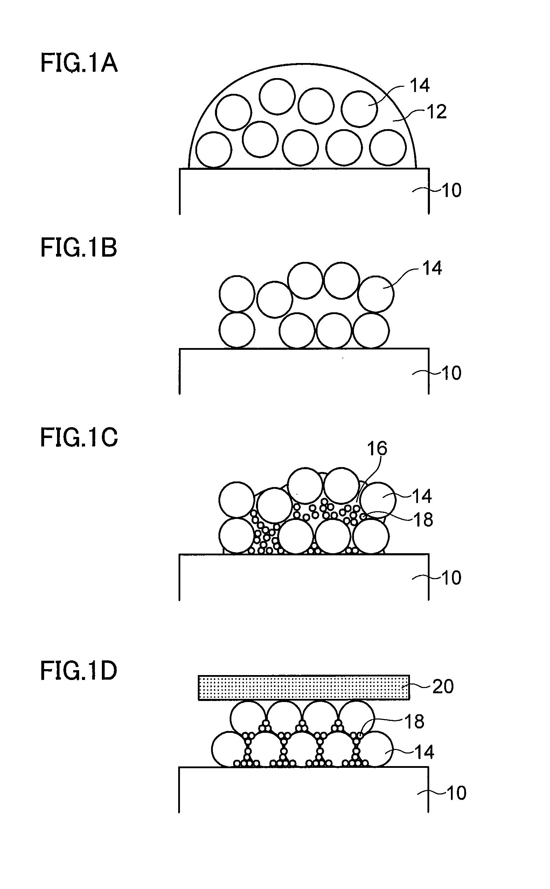

In a method of forming copper wiring according to an embodiment of the present invention, firstly, a first suspension 12 in which a plurality of first copper particles 14 (first copper powder) are dispersed is deposited onto a substrate 10 to form a wiring pattern of the first suspension 12 on the substrate 10 (see Fig. 1A). A width of the wiring pattern is preferably not smaller than 50 µm and not larger than 100 µm, without particular limitations.

<Substrate>

As the substrate 10, substrates of various materials can be used without particular limitations.

### <First Suspension>

The first suspension 12 includes a suspending medium (continuous phase) and the plurality of first copper particles 14 (the first copper powder) dispersed within the suspending medium. The first suspension 12 can include a dispersing agent that is capable of holding the first copper particles 14 in the dispersed state in the suspending medium. The first suspension 12 can further include any additive agent that is evaporated or broken at a temperature not higher than a heating temperature in a heat application step, which is described later. In Fig. 1A, only the first copper particles 14 are particularly depicted among the contents of the first suspension 12.

It is preferable that the first copper powder is constituted of the first copper particles 14 having a number-average particle diameter measured by scanning electron microscopy (SEM) (hereinafter referred to simply as the "particle diameter") that is not smaller than 100 nm and not larger than 300 nm. In the case where the copper particles have the particle diameter that is not smaller than 100 nm, the copper particles do not completely oxidize easily in the air at the normal temperature. On the other hand, in a case where the copper particles have the particle diameter that is smaller than 100 nm, the copper particles completely oxidize easily in the air at the normal temperature.

As the suspending medium, it is possible to use any of various liquids (e.g., cyclohexanone, or the like) without particular limitations, provided that the first copper particles 14 can be dispersed therein.

As the dispersing agent, it is possible to use any of various materials without particular limitations, provided that the material is capable of holding the first copper particles 14 in the dispersed state in the suspending medium. The dispersing agent is made of the material preferably providing the first copper particles 14 with sufficient dispersion stability, and preferably not involving in the conductivity of completed copper wiring.

It is preferable that the first suspension 12 is prepared in a non-oxidizing atmosphere. Although the first copper particles 14 do not easily oxidize in the air at the normal temperature because the first copper powder constituted of the first copper particles 14 having the particle diameter that is not smaller than 100 nm is used in the present embodiment, the preparation of the first suspension 12 in the non-oxidizing atmosphere is useful for preventing the first copper powder from oxidizing.

It is preferable that the first suspension 12 has the viscosity that is not lower than 1 cP and not higher than 20 cP and the surface tension that is not lower than 25 mN/m and not higher than 40 mN/m. By thus adjusting the property of the first suspension 12, it is possible to facilitate insertion of second copper particles 18 into voids between the first copper particles 14 when depositing a second suspension 16, which is described later.

It is possible to prepare the first suspension 12 by mixing the first copper particles of 50 wt% or above and cyclohexanone of 50 wt% or less, for example.

### <Method of Depositing First Suspension>

As the method of depositing the first suspension 12 onto the substrate 10, it is possible to use any of various coating methods such as a spin coating method and a dip coating method, or any of various printing methods such as an inkjet printing method and a screen printing method, without particular limitations. In a case where the inkjet printing method is used among these methods, a desired wiring pattern can directly be drawn on the substrate 10 with the first suspension 12. Moreover, in the case where the inkjet printing method is used, it is possible to selectively deposit the first suspension 12 along a wiring pattern, and it is possible to thereby suppress a use amount of the first suspension 12 and to thus lower a manufacturing cost of copper wiring.

### {First Drying Step}

Next, the suspending medium is removed from the first suspension 12 that has been deposited on the substrate 10 in the pattern formation step, so that the first copper powder is dried (see Fig. 1B). Thereby, it is possible to facilitate insertion of the second suspension 16 into the voids between the first copper particles 14 in the subsequent second suspension deposition step.

It is preferable that the temperature at which the first copper powder is dried in the first drying step is lower than 150°C. It is more preferable that the first copper powder is not heated in the first drying step. By limiting the temperature in the first drying step as described above, it is possible to prevent the first copper powder from oxidizing.

In the first drying step, it is possible to accelerate the drying of the first copper powder by blowing air and/or lowering the atmospheric pressure.

### {Second Suspension Deposition Step}

Next, the second suspension 16, in which the plurality of second copper particles 18 (second copper powder) are dispersed, is deposited onto the wiring pattern formed of the first copper powder that has been dried in the first drying step (see Fig. 1C).

### <Second Suspension>

The second suspension 16 includes a suspending medium (continuous phase) and the plurality of second copper particles 18 (the second copper powder) dispersed within the suspending medium. The second suspension 16 can include a dispersing agent that is capable of holding the second copper particles 18 in the dispersed state in the suspending medium. The second suspension 16 can further include any additive agent that is evaporated or broken at a temperature not higher than the heating temperature in the heat application step, which is described later. In Fig. 1C, only the second copper particles 18 are particularly depicted among the contents of the second suspension 16.

The second copper particles 18 constituting the second copper powder have a particle diameter smaller than the particle diameter of the first copper particles 14. Hence, it is possible to insert the second copper particles 18 into the voids between the first copper particles 14 and to thereby reduce the voids.

The particle diameter of the second copper particles 18 is preferably not larger than 30 nm, and is more preferably not larger than 1/10 of the particle diameter of the first copper particles 14. Hence, the second copper particles 18 can easily enter into the voids between the first copper particles 14. On the other hand, in a case where the particle diameter of the second copper particles 18 is small, the second copper particles 18 easily oxidize in the second suspension deposition step. Therefore, it is preferable that the second copper particles 18 have the particle diameter that prevents easy oxidation at the normal temperature, and have the particle diameter that is not smaller than 10 nm, for example.

As the suspending medium, the dispersing agent and other contents included in the second suspension 16, it is possible to use the materials similar to the first dispersion liquid 12. It is preferable that the second suspension 16 is prepared in a non-oxidizing atmosphere.

It is possible to prepare the second suspension 16 by mixing the second copper particles of 25 wt% or above and cyclohexanone of 75 wt% or less, for example.

It is preferable that the viscosity of the second suspension 16 is not lower than 1 cP and not higher than 20 cP, and is lower than the viscosity of the first suspension 12. Hence, the second suspension 16 can easily enter into the voids between the first copper particles 14. It is preferable that the surface tension of the second suspension 16 is not lower than 25 mN/m and not higher than 40 mN/m.

### <Method of Depositing Second Suspension>

As the method of depositing the second suspension 16 onto the wiring pattern, it is possible to use the method similar to the method of depositing the first suspension 12, without particular limitations.

In a case where the inkjet printing method is used to deposit the second suspension 16, it is possible to selectively deposit the second suspension 16 along the wiring pattern, and it is possible to thereby suppress a use amount of the second suspension 16 and to thus lower the manufacturing cost of the copper wiring. In this case, it is preferable that the size of droplets of the second suspension 16 ejected by the inkjet is smaller than the width of the wiring pattern.

In the case where the inkjet printing method is used to deposit the first suspension 12 and the second suspension 16, it is preferable that the first suspension 12 and the second suspension 16 are ejected from different inkjet heads, respectively. In the present embodiment, since the first and second copper powders are respectively deposited with use of the first and second suspensions, it is possible to improve electivity of properties in the deposition by the inkjet printing method as compared with a case where copper powder constituted of copper particles different in particle diameters is deposited with use of the same suspension. It is preferable that the size of droplets of the second suspension 16 ejected by the inkjet is smaller than the size of droplets of the first suspension 12 ejected by the inkjet. Hence, the second suspension 16 can easily enter into the voids between the first copper particles 14.

### {Second Drying Step}

It is possible to perform, where necessary, a second drying step in which the suspending medium is removed from the second suspension 16 that has been deposited on the wiring pattern, so that the copper powder is dried. In this case, it is preferable that the second drying step is performed after elapse of a time that is long enough to complete entrance of the second copper particles 18 into the voids between the first copper particles 14.

It is also possible not to perform the second drying step. In this case, the suspending medium of the second suspension 16 is left to maintain flowability of the second suspension 16, which makes it possible to keep the state where the second copper particles 18 can easily enter into the voids between the first copper particles 14. It is also possible to reduce process time.

### {Compaction Step}

Next, the voids between the first copper particles 14 and the second copper particles 18 are reduced, so that the copper powder forming the wiring pattern is compacted (see Fig. 1D).

For example, it is possible to compress and thereby compact the copper powder by applying pressure with a pressing device 20 as shown in Fig. 1D. In the present embodiment, since the second copper particles 18 have been inserted in the voids between the first copper particles 14 in the second suspension deposition step, the compaction step can be performed in the state where the voids are smaller than those in a case where the second copper particles 18 are not deposited. Therefore, it becomes possible to make the pressure applied for the compaction relatively low, and to thereby suppress an adverse effect on the substrate 10.

By performing the compaction step, it becomes possible to suppress a deposition amount of the second copper particles 18, and to thereby lower the manufacturing cost of the copper wiring.

Examples of the pressure application method in the compaction step include a calendering process. It is preferable that the pressure applied to the copper powder in the compaction step is not lower than 100 MPa and not higher than 300 MPa.

### {Heat Application Step}

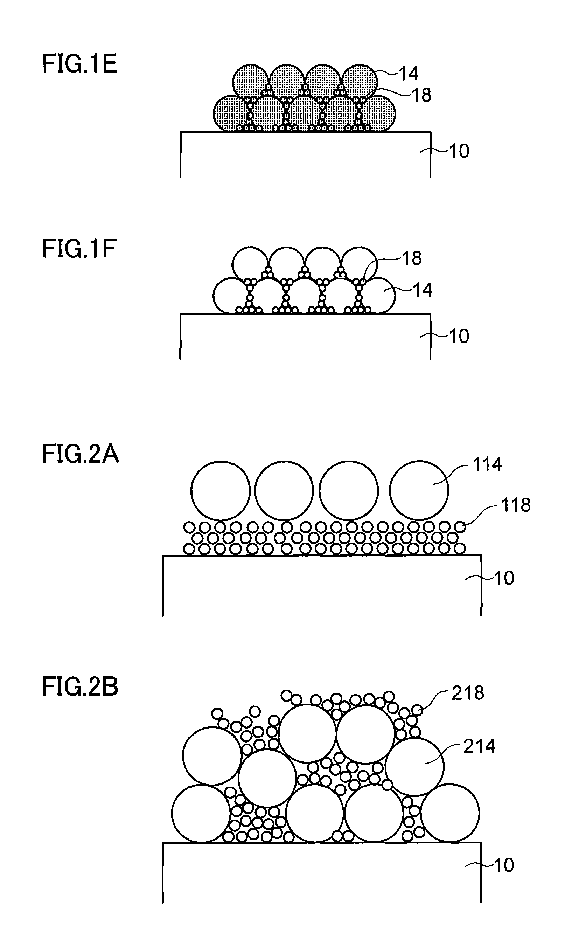

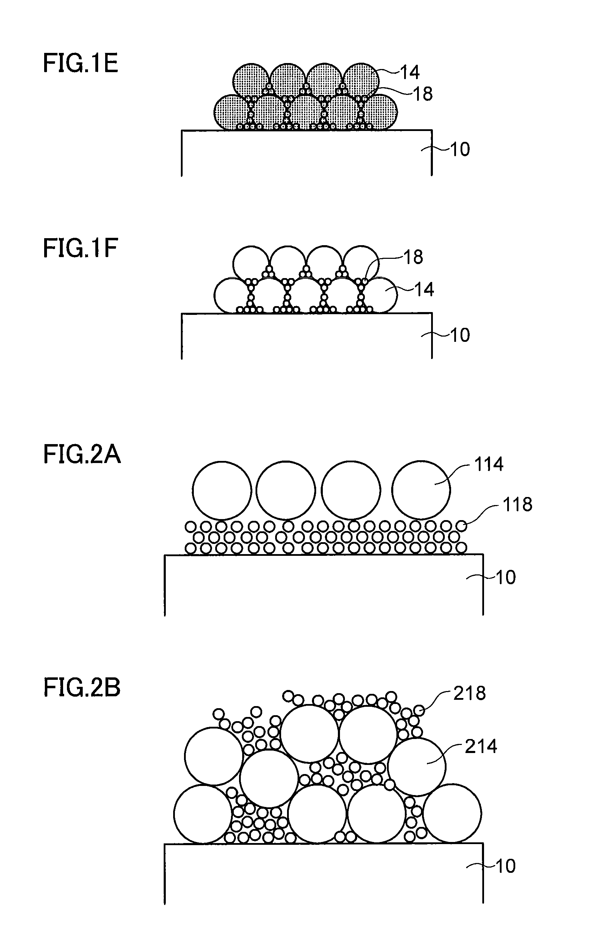

Next, heat is applied in the air to the copper powder that has been compacted in the compaction step, so as to make the first copper particles 14 and the second copper particles 18 bond to each other concurrently with oxidizing (see Fig. 1E).

It is preferable to determine the heating temperature in the heat application step according to the particle diameter of the first copper particles 14 constituting the first copper powder. In order to impart conductivity to the wiring pattern, it is preferable to heat, in the heat application step, the copper powder at a higher temperature as the particle diameter of the copper particles constituting the copper powder becomes larger. For example, in a case where the first copper particles 14 constituting the first copper powder have the particle diameter that is not smaller than 100 nm and not larger than 200 nm, conductivity can be imparted to the wiring pattern if the heating temperature in the heat application step is not lower than 150°C. For example, in a case where the first copper particles 14 constituting the first copper powder have the particle diameter that is larger than 200 nm, conductivity can be imparted to the wiring pattern if the heating temperature in the heat application step is not lower than 200°C.

In the present embodiment, it is preferable to perform the heat application step after the compaction step. After reducing the voids between the copper particles forming the wiring pattern, it is possible to further increase mutual contact areas between the copper particles by making the copper particles oxidize and bond to each other with the heat application. If the order of performing the compaction step and the heat application step is reversed (i.e., the compaction step is performed after the heat application step), the compaction step is performed on the copper powder in the state where the copper particles have already bonded to each other by heat in the heat application step, and this makes it difficult to reduce the voids between the copper particles to compact the copper powder. If the compaction step and the heat application step are simultaneously performed on the copper powder, the copper particles bond to each other in the state where the copper powder is not sufficiently compacted, and it is then impossible to secure sufficient mutual contact areas between the copper particles. It is preferable, therefore, to perform the compaction step first and to thereafter perform the heat application step.

### {Reducing Treatment Step}

Next, the copper powder having oxidized in the heat application step is reduced so as to impart conductivity to the copper powder forming the wiring pattern (see Fig. 1F). Thereby, it is possible to make the first copper particles 14 and the second copper particles 18, which have bonded to each other, function as wiring.

As the reducing treatment, it is possible to use any of various treatments without particular limitations. For example, it is possible to reduce the oxidized copper powder by heating at a temperature of not lower than 350°C and not higher than 400°C in an argon atmosphere containing hydrogen of not less than 3 vol% and not more than 10 vol%.

### <Copper Wiring>

The width of the copper wiring formed in the present embodiment is, for example, not smaller than 50 µm and not larger than 100 µm, without particular limitations. The copper wiring formed in the present embodiment can be used as wiring for wiring boards.

According to the present embodiment, in the wiring pattern formation step, the wiring pattern is formed with use of the first copper particles having the large particle diameter, and in the subsequent second suspension deposition step, the second copper particles having the particle diameter smaller than the particle diameter of the first copper particles are deposited onto the wiring pattern to fill the voids between the first copper particles with the second copper particles, so that the copper wiring with small voids can be formed. Therefore, it is possible to improve conductivity as well as temporal stability in the completed copper wiring.

### {Comparative Examples}

Fig. 2A shows a first comparative example, where second copper particles 118 having a small particle diameter are deposited on a substrate 10 first, and thereafter first copper particles 114 having a large particle diameter are deposited. In this case, a layer of the first copper particles 114 is merely formed on a layer of the second copper particles 118, and it is not possible to obtain any effect of the second copper particles 118 filling voids between the first copper particles 114.

Fig. 2B shows a second comparative example, where a suspension is prepared in which both first copper particles 214 having a large particle diameter and second copper particles 218 having a small particle diameter are dispersed, and the suspension is deposited on a substrate 10. In this case, some of the second copper particles 218 enter into voids between the first copper particles 214. However, some of the second copper particles 218 remain on the first copper particles 214, and are then wasted with producing no effect of filling the voids between the first copper particles 214.

### Explanation of Reference Numerals

10: substrate; 12: first suspension; 14: first copper particles; 16: second suspension; 18: second copper particles; 20: pressing device

## Claims

1. A method of forming copper wiring, the method comprising:
a wiring pattern formation step of depositing a first suspension onto a substrate to form a wiring pattern of the first suspension on the substrate, the first suspension including dispersed first copper particles having an average particle diameter that is not smaller than 100 nm;
after the wiring pattern formation step, a drying step of drying the first copper particles in the wiring pattern at a temperature lower than 150°C;
after the drying step, a second suspension deposition step of depositing a second suspension onto the wiring pattern, the second suspension including dispersed second copper particles having an average particle diameter that is smaller than the average particle diameter of the first copper particles;
after the second suspension deposition step, a compaction step of reducing voids between the first and second copper particles in the wiring pattern;
after the compaction step, a heat application step of applying heat to the first and second copper particles in the wiring pattern; and
after the heat application step, a reducing treatment step of subjecting the first and second copper particles in the wiring pattern to a reducing treatment.

2. The method of forming copper wiring as defined in claim 1, wherein the compaction step includes a pressure application step of applying pressure to the first and second copper particles in the wiring pattern.

3. The method of forming copper wiring as defined in claim 1 or 2, wherein:
the wiring pattern formation step includes a first suspension ejection step of ejecting droplets of the first suspension by means of an inkjet method to deposit the droplets of the first suspension onto the substrate; and
the second suspension deposition step includes a second suspension ejection step of ejecting droplets of the second suspension by means of the inkjet method to deposit the droplets of the second suspension onto the wiring pattern.

4. The method of forming copper wiring as defined in claim 3, wherein a size of the droplets of the first suspension in the first suspension ejection step is larger than a size of the droplets of the second suspension in the second suspension ejection step.

5. The method of forming copper wiring as defined in claim 3 or 4, wherein the first suspension ejection step and the second suspension ejection step are carried out respectively by means of inkjet heads different from each other.

6. The method of forming copper wiring as defined in any of claims 1 to 5, wherein the average particle diameter of the second copper particles is not larger than 1/10 of the average particle diameter of the first copper particles.

7. The method of forming copper wiring as defined in any of claims 1 to 6, wherein a viscosity of the second suspension is lower than a viscosity of the first suspension.

8. A method of manufacturing a wiring board, comprising the method of forming copper wiring as defined in any of claims 1 to 7.

9. A wiring board, comprising the copper wiring formed by the method of forming copper wiring as defined in any of claims 1 to 7.
